# EUROPEAN PATENT APPLICATION

(11) **EP 0 810 657 A2**
(43) Date of publication of application: **03.12.1997**
(21) Application number: 97303678.3
(22) Date of filing: 02.06.1997
(51) Int. Cl.: H01L 23/473

(54) **Heat sink with coolant accelerator**

(30) Priority: 31.05.1996 US 656513
(71) Applicant: R-Theta Inc., Mississauga, Ontario L4Z 1Y6 (CA)
(72) Inventor: Butler, James R.S., Oakville, Ontario, 16J 3A3 (CA); Radosevic, Michael, Mississauga, Ontario, L5M 5Z7 (CA); Fast, David W., Brantford, Ontario, N3R 7B2 (CA); Chilanski, Mario J., Kitchener, Ontario, N2G 1Z5 (CA); Rampersaud, Deo, Mississauga, Ontario L5W 1H1 (CA)
(74) Representative: Naismith, Robert Stewart

(57) **Abstract**

A liquid cooled heat sink for removing unwanted heat from a heat source, comprising a thermal conductive surface (15) connected to the heat source; a front end head (5) of predetermined diameter for receiving a supply of cooling liquid at a predetermined volumetric flow rate; a rear end head (7) of the predetermined diameter for outputting the cooling liquid at the volumetric flow rate; a plurality of pipes (9) of the predetermined diameter connected outwardly to the heat source for conveying the cooling liquid between the front end head (5) and the rear end head (7) thereby withdrawing the unwanted heat from the heat source via the thermal conductive surface (15); and an insert (13) in at least one of the plurality of pipes (9) for accelerating flow of the cooling liquid in the at least one of the plurality of pipes thereby enhancing thermal performance of the heat sink.

## Description

The present invention relates in general to heat sinks, and more particularly to a liquid cooled heat sink with coolant accelerator.

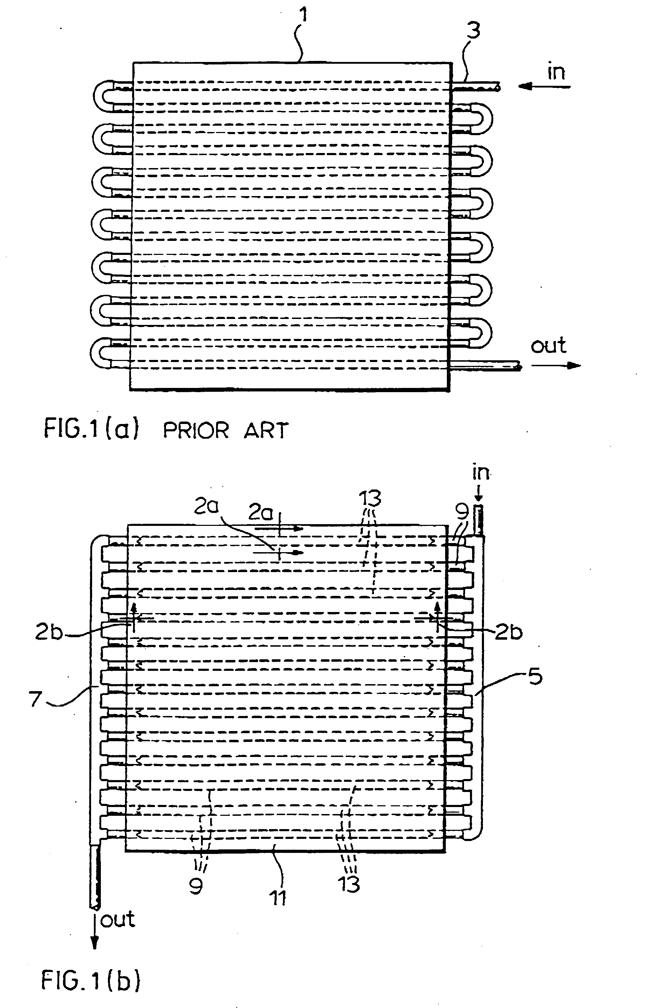

Liquid cooled heat sinks are known in the prior art for removing heat from electronic components. One such liquid cooled heat sink is illustrated in Fig. 1(a). This heat sink typically comprises an aluminium block 1 incorporating a tube channel 3 which winds it way several times through the heat sink. The temperature of the cooling liquid increases as it passes through the serpentine channel 3, picking up heat from the electronic components being cooled. This results in uneven cooling and lower life expectancy of the components towards the end of the serpentine channel 3.

According to the present invention, there is provided a liquid cooled heat sink for removing unwanted heat from a heat source, comprising:
a) a thermal conductive surface connected to said heat source;
b) a front end heat of predetermined diameter for receiving a supply of cooling liquid at a predetermined volumetric flow rate;
c) a rear end heat of said predetermined diameter for outputting said cooling liquid at said volumetric flow rate;
d) a plurality of pipes of said predetermined diameter connected outwardly to said heat source for conveying said cooling liquid between said front end heat and said rear end heat thereby withdrawing said unwanted heat from said heat source via said thermal conductive surface; and
e) an insert in at least one of said plurality of pipes for accelerating flow of said cooling liquid in said at least one of said plurality of pipes thereby enhancing thermal performance of said heat sink.

Therefore, according to one aspect of the present invention, as discussed in greater detail below with reference to the drawings, parallel paths of flow are provided rather than a single winding tube channel in order to provide a balanced temperature gradient over the whole heat collecting surface.

In order to achieve similar thermal performance as the prior art serpentine arrangement of Fig. 1(a), the parallel flow arrangement according to the present invention must provide the same average fluid velocity in each of the parallel paths. Since volumetric flow rate is determined by the pump system (i.e. a constant flow rate), each parallel path receives only a fraction of the liquid flow which is supplied to the heat sink. Therefore, the cross-sectional area of each of the parallel paths must be adjusted to compensate for the lower flow rate. The insert or accelerator of the present invention is provided in each of the parallel flow paths for accelerating the flow of cooling liquid, thereby enhancing thermal performance of the heat sink.

A detailed description of the preferred embodiment is provided herein below with reference to the following drawings in which:
Fig. 1(a) shows a series-connected liquid cooled heat sink according to the prior art;
Fig. 1(b) shows a parallel flow liquid cooled heat sink according to the present invention;
Fig. 2(a) is a cross-section through the line 2A-2A in Fig. 1(b), showing an insert according to the preferred embodiment; and
Fig. 2(b) is a cross-section through the line 2B-2B in Fig. 1(b), showing the insert of the preferred embodiment.

With reference to Fig. 1(b), the heat sink of the present invention comprises a front end header 5, a rear end header 7, a plurality of parallel tube channels 9 connected to the headers 5 and 7 and housing within a thermally conductive block 11.

A plurality of heat generating electronic components are arranged on the surface of thermally conductive block 11 so that liquid flowing through the parallel paths or tube channels 9 absorbs the heat in accordance with standard heat exchange principles. As indicated above, according to the present invention, each parallel tube 9 is preferably provided with an insert or accelerator 13 for blocking part of the fluid flow and thereby increasing velocity within the channel tube 9.

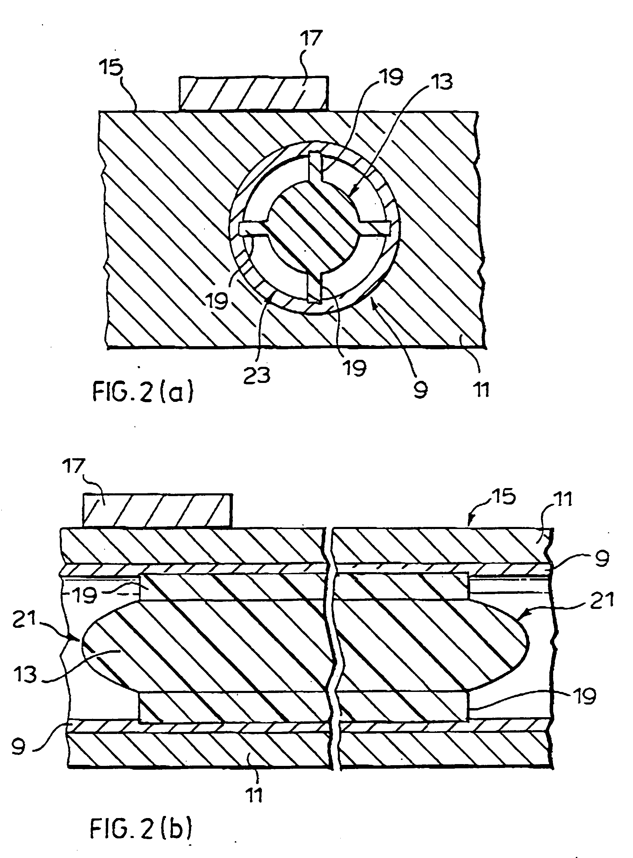

Turning to Figs. 1(a) and 2(b), the channel tube 9 is shown disposed within thermally conductive block 11. A surface 15 of the block 11 is in contact with a plurality of heat generating electronic devices, shown schematically in Figs. 2(a) and 2(b) by reference numeral 17. Preferably, the block 11 is an aluminium block into which copper tube 9 is inserted and expanded using conventional techniques.

The insert 13 is shown as being of generally cylindrical shape and is secured within the copper tube 9 via interference fit by means of a plurality of ribs 19. Opposite ends 21 of the insert 13 are preferably of conical shape. The insert 13 may be fabricated from plastic or other suitable material.

In operation, the insert 13 causes fluid flow to accelerate around an annulus between the inside surface 23 of the copper tube and the outside of the insert or accelerator 13, thereby increasing the velocity of fluid flow. Therefore, considered one way, by keeping a constant diameter of tube 9, the provision of insert 13 increases by velocity of fluid flow, thereby enhancing the heat transfer characteristics relative to a tube of similar diameter without an insert. Or, considered an another way, by enlarging the diameter of the copper tube 9, and providing insert 13 to maintain a fluid flow which is similar to the fluid flow of a smaller diameter tube without an insert, the heat transfer surface area is thereby increased, thus improving overall thermal performance.

Studies have been conducted to identify the benefits of the insert 13 relative to the diameter of copper tube 9. These studies have shown that, for a constant volumetric flow rate, constant channel diameter (D) of the tube 9, a smooth channel surface, and a correlation for friction factor in the range of 4000<Reynolds no. <200000 utilised for head loss calculations, increases in average velocity of fluid flow and conductances are observed for different diameters (X). Table 1 shows increases in velocity, conductance and heat loss for different ratios of insert diameter (X) to channel diameter (D), from which it is evident that a 0.5 insert is feasible with a trade off of 326% increase in heat loss for a 30% gain in conductance.

**Table 1 :**

| Effect of Insert Due to Increase in Velocity | | | |
|---|---|---|---|
| | | Increase In | |
| X/D | Velocity | Conductance | Head Loss |
| 0.5 | 1.33 | 1.31 | 4.26 |
| 0.7 | 1.96 | 1.71 | 15.8 |

As discussed above, the insert 13 may also be used to increase the surface area of heat transfer by enlarging the channel diameter and maintaining the same average velocity as would characterise a lesser diameter channel. An analytical investigation has been conducted to study this aspect of operation, based on the following assumption: constant volumetric flow rate, constant cross-sectional flow area (maintained constant by enlarging the channel diameter (D) and choosing an appropriate insert diameter (X)), smooth channel surface, and correlation for the friction factor in the range 4000<Reynolds no.<200000 for head loss calculations. The result of this investigation are reproduced in Table 2.

**Table 2 :**

| Effect of Insert Due to Increase in Surface | | | |
|---|---|---|---|
| | | Increase In | |
| X/D | Velocity | Conductance | Head Loss |
| 0.5 | 1.15 | 1.21 | 1.96 |
| 0.7 | 1.40 | 1.44 | 2.90 |

Table 2 illustrates that utilising insert 13 for the sake of increasing the surface area and keeping the flow rate the same as would be provided with a lesser diameter tube channel, results in less significant head loss increases than shown in Table 1. Table 2 implies that by increasing the channel diameter (D) to 1.4 times its original diameter and incorporating a 0.7 insert, a 44% increase in conductance can be realised compromised by a 190% increase in head loss.

From the foregoing studies, it is apparent that for an insert 13 having a cross-sectional area which is approximately half that of the cross-sectional area of the tube 9, significant gains are obtained. In practice, the cross-section area of the insert will be application specific, depending on the number of parallel channels and the pump capacity.

According to a successful prototype of the invention, the thickness of tube 9 is 0.049 inches, the diameter of insert 13 is 0.342 inches, the diameter of tube channel 9 is 0.521 inches and the thickness of each rib 19 is 0.040 inches. This results in a cross-sectional area of the insert 13 being 0.1062in² and a cross-sectional area of the tube 9 being 0.2132in².

The preferred length of the insert 13 within channel tube 9 is equal to the length of the conductive block 11 parallel to the tube(s) 9, although for manufacturing reasons the insert may in fact be approximately 2" shorter than the imbedded tube 9, approximately 1" set back from each end.

Other embodiments and variations of the invention are contemplated. For example, in some circumstances, in addition to the parallel tube channels 9, it may be desirable to have one or more series connected pipes, depending on the configuration of heat generating elements to be connected to the heat sink. Also, there may be applications in which an insert is not required in each tube 9. Furthermore, the inside surface 23 of the tube 9 may be scribed or grooved to receive the fins 19 to enhance the interference fit.

All such embodiments or variations are believed to be within the sphere and scope of the present invention as defined by the claims appended hereto.

## Claims

1. A liquid cooled heat sink for removing unwanted heat from a heat source, comprising:
a) a thermal conductive surface (15) connected to said heat source;
b) a front end heat (5) of predetermined diameter for receiving a supply of cooling liquid at a predetermined volumetric flow rate;
c) a rear end heat (7) of said predetermined diameter for outputting said cooling liquid at said volumetric flow rate;
d) a plurality of pipes (9) of said predetermined diameter connected outwardly to said heat source for conveying said cooling liquid between said front end heat (5) and said rear end heat (7) thereby withdrawing said unwanted heat from said heat source via said thermal conductive surface; and
e) an insert (13) in at least one of said plurality of pipes (9) for accelerating flow of said cooling liquid in said at least one of said plurality of pipes thereby enhancing thermal performance of said heat sink.

2. A liquid cooled heat sink as claimed in claim 1, wherein said insert (13) further comprises a cylindrical portion of further diameter less than said predetermined diameter, thereby creating an annulus there between, and at least two ribs (19) for securing said insert (13) inside said at least one of said plurality of pipes (9).

3. A liquid cooled heat sink as claimed in claim 1 or 2, wherein said insert is characterised by a cross-sectional area which is approximately one half that of said at least one of said plurality of pipes (9).

4. A liquid cooled heat sink as claimed in claim 2 or 3, wherein said insert (13) further comprises a pair of conical extensions (21) from opposite ends of said cylindrical portion.

5. A liquid cooled heat sink as claimed in any preceding claim, wherein said insert (13) is secured within said at least one of said plurality of pipes (9) via an interference fit.

6. A liquid cooled heat sink as claimed in claim 5, wherein said at least one of said plurality of pipes (9) further includes at least two grooves for receiving said at least two ribs (19).

7. A liquid cooled heat sink as claimed in any preceding claim, wherein said insert (13) is characterised by a length which is approximately the same as that of said at least one of said plurality of pipes (9).

8. A liquid cooled heat sink as claimed in any preceding claim, wherein said thermal conductive surface comprises an aluminium block (11).

9. A liquid cooled heat sink as claimed in claim 1, wherein said plurality of pipes (9) are copper tubes inserted in said aluminium block (11).
